# EUROPEAN PATENT APPLICATION

(11) **EP 4 761 036 A1**
(43) Date of publication of application: **17.06.2026**
(21) Application number: 25223478.6
(22) Date of filing: 15.12.2025
(51) Int. Cl.: H02J 4/10, H02J 9/04, H02J 9/06, H02J 13/18, H02J 13/36, H02J 13/38

(54) **RACK POWER DISTRIBUTION UNIT FOR LEAK DETECTION MANAGEMENT**

(30) Priority: 13.12.2024 US 202463733829 P; 11.12.2025 US 202519416966
(71) Applicant: Vertiv Corporation, Westerville, OH 43082 (US)
(72) Inventor: FERGUSON, Kevin, Westerville, 43082 (US); POTTER, Benjamin, Westerville, 43082 (US); HOGE, Gregory M., Westerville, 43082 (US)
(74) Representative: Bryn-Jacobsen, Caelia

(57) **Abstract**

A power distribution unit may include a housing, a power input interface configured to couple to an electrical distribution element, and a plurality of power output interfaces configured to couple to a plurality of output cables. The power distribution unit may include a switch-mode power supply (SMPS) configured to receive a disconnect power and transmit the disconnect power to one or more relays. The power distribution unit may include one or more relays configured to transmit the disconnect power to a voltage coil of an overcurrent protective device upon receiving a disconnect signal, wherein the overcurrent protective device is configured to receive a first power from a power source. The power distribution unit may include a leak detection sensor and a controller communicatively coupled to the leak detection sensor and one or more relays.

## Description

### CROSS REFERENCE TO RELATED APPLICATION

This application claims the benefit of priority of U.S. Provisional Application No. 63/733,829, filed December 13, 2024.

### TECHNICAL FIELD

The present disclosure relates generally to controlling power flow in a server rack, and more particularly, to monitoring coolant leaks and controlling power flow in a liquid-cooled server rack.

### BACKGROUND

Rack-mounted power distribution units (PDUs) support the power demands of power supply units, such as power supply units coupled to computer servers. When designing distribution systems for high-workload computer servers, such as computer servers for high-performance computing (HPC) or artificial intelligence (AI) computing, conventional higher ampacity three-phase power distribution systems are usually considered. The rack PDU may also provide power to electronic equipment and CPU/GPU servers directly or indirectly via Open Compute Power (OCP), Open Rack (OR), or other compliant power shelves. Many newer computer power systems use liquid cooling technologies. Often, components of these liquid cooling technologies (e.g., manifolds, hoses, and couplings), compete for space within the rack along with the power components and power equipment. Because of this, there is a need to monitor the floor, subfloor, and/or perimeter of the rack for liquid leaks, and take immediate protective action to de-energize all the power distribution equipment upon the leak detection event to mitigate the potential of an electrical shock safety hazard. Current liquid-cooled rack systems lack proper monitoring for liquid leaks and/or are not able to effectively de-energize power distribution equipment upon leak detection. Therefore, there is a need for systems and methods for monitoring rack systems for liquid leaks and de-energizing power distribution equipment upon detection of a liquid leak.

### SUMMARY

Accordingly, the present disclosure is directed to a system and method for managing leak detection and power distribution in a power distribution unit.

In some examples, the techniques described herein relate to a power distribution unit of a power system for powering electronic equipment, the power distribution unit including: a housing; a power input interface configured to couple to an electrical distribution element; a plurality of power output interfaces configured to couple to a plurality of output cables; a plurality of switch-mode power supplies (SMPS) configured to: receive a disconnect power and transmit the disconnect power to one or more relays; one or more relays configured to transmit the disconnect power to a voltage coil of an overcurrent protective device upon receiving a disconnect signal, wherein the overcurrent protective device is configured to receive a first power from a power source; a leak detection sensor; and a controller communicatively coupled to the leak detection sensor and the one or more relays, the controller including one or more processors configured to execute a set of program instructions stored in a memory, the set of program instructions configured to cause the one or more processors to: receive a leak detection data from the leak detection sensor; determine if there is a power leak within the power system based on the leak detection data; and upon a determination of the power leak, transmitting the disconnect signal to the one or more relays.

In some examples, the techniques described herein relate to a method for managing leak detection by a power distribution unit of a power system, the method including: receiving a leak detection data from a leak detection sensor; determining if there is a power leak within the power system based on the leak detection data; and upon a determination of the power leak, transmitting a disconnect signal to one or more relays; closing the relay based on the disconnect signal; and transmitting a disconnect power to an overcurrent protection device via the relay.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF DRAWINGS

The numerous advantages of the disclosure may be better understood by those skilled in the art by reference to the accompanying figures.
FIG. 1 illustrates a block diagram of a power system that includes a power distribution unit, in accordance with one or more examples of the disclosure.
FIG. 2 illustrates a block diagram of a power system that includes a power distribution unit, in accordance with one or more examples of the disclosure.
FIG. 3 illustrates a front view of a power distribution unit configured with two electrical distribution elements and eight whips, in accordance with one or more examples of the disclosure.
FIG. 4 illustrates a front view of a power distribution unit configured with two electrical distribution elements and four whips, in accordance with one or more examples of the disclosure.
FIG. 5 illustrates a front view of a power distribution unit configured with four electrical distribution elements and four whips, in accordance with one or more examples of the disclosure.
FIG. 6 illustrates a process flow diagram depicting a method 600 for managing leak detection by a power distribution unit, in accordance with one or more examples of the disclosure.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "examples" means that a particular element, feature, structure, or characteristic described in connection with the example is included in at least one example disclosed herein. The appearances of the phrase "in examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

Examples of the present disclosure are directed to a power distribution unit (PDU) within a power system for powering electronic equipment, such as computer server racks within a data center. The PDU is electrically coupled to one or more overcurrent protection devices (OCPD) (e.g., breakers) for controlling the flow of power (e.g., alternating current (AC) or direct current (DC) between a power source and a power load. The PDU includes and/or is communicatively coupled to sensors for detecting directly or indirectly a liquid, such as liquid leaking from a liquid cooling system. The PDU further includes power supplies and relays that can direct a disconnect power to the OCPD upon the sensors detecting a liquid leak, ultimately resulting in a tripping of the OCPD, causing both the PDU and the electronic equipment powered by the PDU to de-energize.

Examples of the present disclosure are particularly advantageous for monitoring power in data centers, particularly data centers using liquid cooling systems. For example, current systems use OCPDs that are distributed within multiple overhead busway tap-off boxes, Remote Power Panels (RPP), or distally at the origin of upstream power distribution, rather than within a single housed unit as disclosed herein. The disparate locations of these OCPDs complicate the coordination and reliability of sensing, monitoring, and controls. The PDU further provides flexibility and adaptability for a variety of installation needs and may support management of remotely located OCPDs.

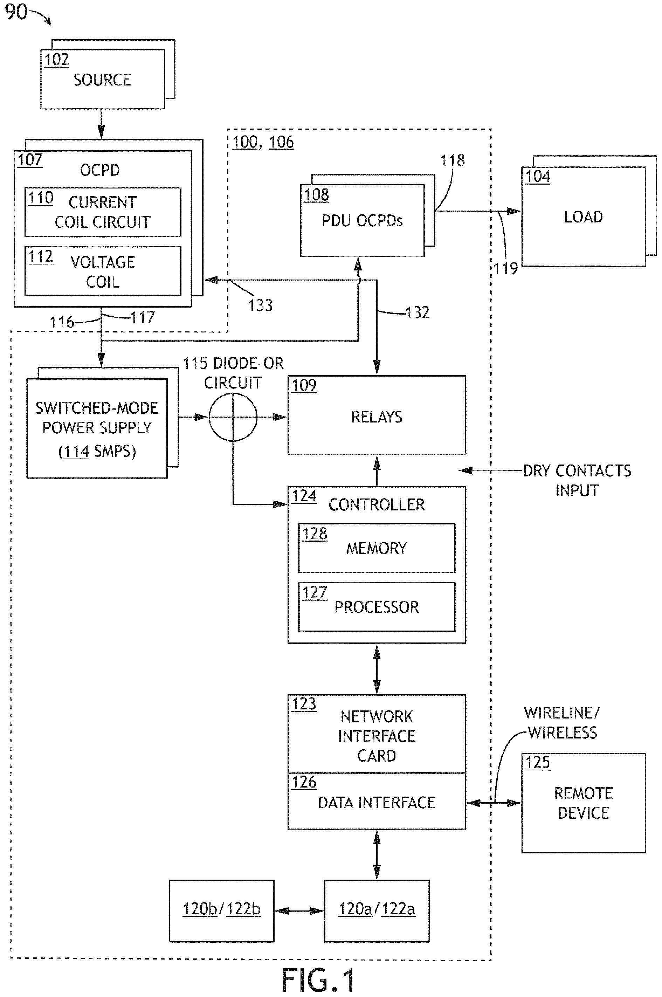

FIG. 1 illustrates a block diagram depicting a power system 90 that includes a PDU 100, in accordance with one or more examples of the disclosure. The PDU 100 may be used for distributing power between a power source 102 and a load 104. For example, the PDU 100 may be configured to receive power (e.g., three-phase AC power or DC power) from a busway or other power source, and distribute the power to a plurality of servers, or to one or more power units that further distribute power to a plurality of servers.

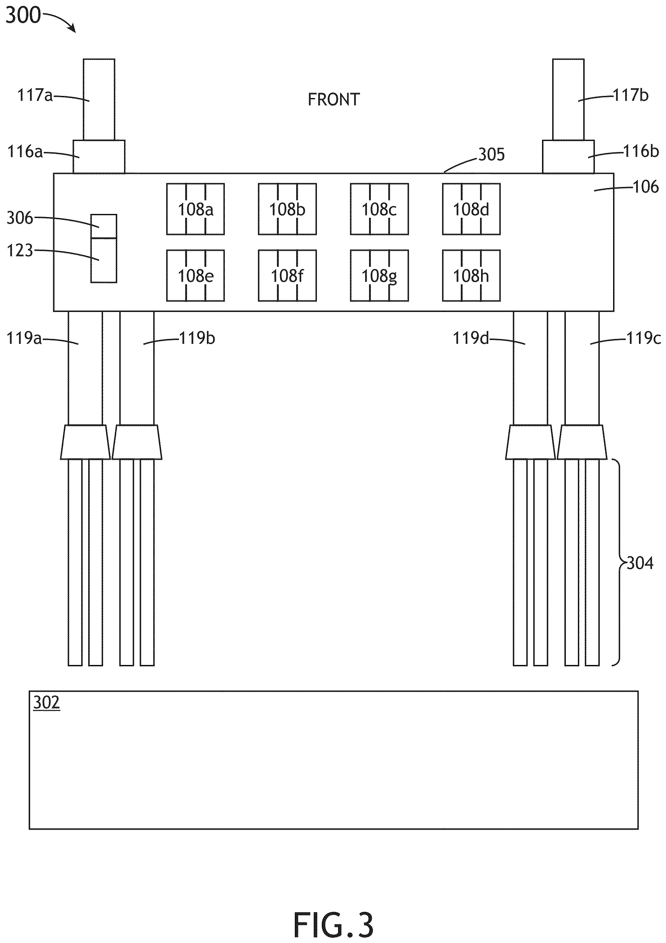

In examples, the PDU 100 includes a housing 106 that houses one or more components of the PDU 100. The housing 106 may incorporate one of several sizes and shapes. For example, the housing 106 may incorporate a horizontal rack mount housing style, allowing the PDU 100 to be placed above the rack, as shown in FIGS. 3-5. The PDU 100 may also be installed in a different position, orientation or within a separate cabinet adjacent to the rack. Therefore, the description herein should not be interpreted as a limitation on the examples of the present disclosure but merely as an illustration.

In examples, the PDU 100 is electrically coupled to one or more upstream OCPDs 107 that protect the power system 90 against excessive overcurrents, such as short circuits and overloads. Shunt trip actions produced by the PDU are signaled to the OCPD 107 of the upstream power sources 102 (e.g., a remote power panel, a busway, or tap-off box (TOB). The OCPD 107 may include a dual coil type of electrical protection circuit. For example, the OCPD 107 may include a relay trip dual coil type of electrical protection circuit. Relay trip dual coil-type OCPDs 107 are typically four-terminal devices that include a current coil circuit 110 and a voltage coil 112. The current coil circuit 110 acts as a sensor, causing the OCPD 107 to trip when current flow (e.g., from the source 102) over a predetermined threshold is detected. The voltage coil 112 is electrically isolated from the current coil circuit 110, which allows triggering or energizing of the voltage coil 112 by an independent voltage source that is separate from the first power source 102. For example, an electrical pulse to the voltage coil 112 (e.g., from a switch-mode power supply (SMPS) output) may trip the OCPD 107, causing the OCPD to interrupt power from the source 102. If the upstream OCPD 107 is not tripped, power (e.g., a first power) may then flow to the load 104 (e.g., via PDU OCPDs 108).

The OCPDs 107 may include any type of protective circuitry. For example, one or more of the plurality of OCPDs 107 may include a hydraulic magnetic-type OCPD 107, which are often used in rack PDUs 100. Hydraulic magnetic-type OCPDs 107 often utilize a fluid-filled current coil for slow tripping for less severe overcurrent conditions (e.g., between 100-125% of rating), and/or fast tripping during excessive overcurrent events (e.g., greater than 200% rating). In another example, one or more of the plurality of OCPDs 107 may include a thermomagnetic-type circuit breaker, which is often utilized in busway tap boxes. Thermomagnetic-type circuit breakers use a bimetallic trip element that bends as current flow heats it up for slow tripping and uses a non-fluid-filled current coil for fast tripping. Other types of OCPDs include, but are not limited to, equipment leakage circuit interrupters, electronic circuit breakers, fuses, overload relays, and shunt trip circuit breakers.

In examples, the PDU 100 includes one or more relays 109. The one or more relays are configured to transmit a disconnect power to the voltage coil 112. For example, upon receiving a disconnect signal from a controller, the one or more relays 109 may activate, causing disconnect power to transmit to the voltage coil 112, tripping the OCPD.

In examples, the PDU 100 includes a plurality of power supplies, such as a plurality of switch-mode power supplies (SMPS 114), to receive power (e.g., AC or DC) and transmit the power to one or more relays 109. For example, SMPSs 114 may utilize switching regulator componentry, such as metal-oxide-semiconductor field-effect transistors (MOSFETs) for controlling power flow.

In examples, the PDU includes a diode-OR circuit 115 or ORing diode coupled to the plurality of SMPS 114. The diode-OR circuit is configured to decouple the plurality of SMPS, ensuring the failure of one SMPS 114 does not result in a de-energizing of the PDU 100. For example, the PDU 100 may include multiple SMPS 114 where disconnect power is received by the diode-OR circuit 115 before being received by the one or more relays.

In examples, the PDU 100 is configured to receive power (e.g., a first power) from a power input interface 116 (e.g., connected to an electrical distribution element 117), and transmit the power to one or more power output interfaces 118 (e.g., connected to a shroud 119 containing whips). For example, the PDU may transmit primary AC or DC power to a series of whips coupled to the power output interfaces 118. The electrical distribution element 117 may include any type of component capable of distributing power to the power unit interface 116a-b, including, but not limited to, a busway, a cable, a busbar, a bus duct, and a cable/conduit sub-system. The shroud 119 may include any type of cabling system for distributing power, including, but not limited to, whips, cables, and cable/conduit systems. The shroud 119 and/or cables may also include a branched or combination architecture. For example, the shroud 119 and/or cables may include a cable that branches into two or more whips. The whips 304 may be detachable or non-detachable. Further, while some PDUs 100 may include shrouds 119, or other PDUs 100, such as an intermediate PDB, do not use shrouds 119. Instead, whips, such as detachable whips, may be oriented horizontally, following a plane of a top side of a rack, where the whips then ingress into the rack at a top back side.

It should be understood that while there may be smaller branch circuit OCPDs (e.g., PDU OCPDs 108) residing within the PDU 100 to protect the output whips from overcurrent conditions, the trip action described herein refers to the shunt trip action produced by the PDU 100 that is signaled to the OCPD 107 of the upstream power supplies (e.g., sources 102). Therefore, the description herein should not be interpreted as a limitation on the examples of the present disclosure, but merely as an illustration.

In examples, the power system 90 and/or PDU 100 include one or more internal sensors 120a, 120b and/or one or more external sensors 122a, 122b (e.g., external to the housing 106). For example, the power system 90 and/or PDU 100 may include internal sensors 120a, 120b and/or an external sensor 122a, 122b that indirectly or directly senses a coolant leak. For instance, the internal sensors 120a, 120b and external sensors 122a, 122b may include devices that monitor and/or detect changes in power flow (e.g., hysteresis) in the power system 90 and/or PDU 100 that would indicate the presence of a coolant leak. Devices that monitor and/or detect changes in power flow and hysteresis may include, but are not limited to, current transformers, oscilloscopes, LCR meters, hall effect sensors, power analyzers, and digital multimeters. In another instance, the internal sensor 120a, 120b and external sensor 122a, 122b may include devices that detect liquid leaks more directly, including, but not limited to, voltage sensing devices, insulation resistance testers, power quality analyzers, leak detection sensors, ultrasonic leak detectors, infrared cameras, pressure sensors, flow meters, water leak detection mats, and conductivity probes. Other sensors may include, but not be limited to, temperature sensors, humidity sensors, energy meters, and a trip coil monitoring sensor configured to detect a failed voltage coil 112 and/or current coil circuit 110. In examples, the sensors may be connected and/or daisy-chained. For example, the internal sensor 120b may be communicatively coupled to internal sensor 120a. In another example, external sensor 122b may be communicatively coupled to external sensor 122a.

In examples, the PDU 100 includes or is configured to be communicatively coupled to a network interface card 123 (e.g., a web card). The network interface card 123 may be coupled to one or more sensors 120, 122, one or more controllers 124, and/or other components of the PDU 100. The network interface card 123 is configured to exchange data between components of the PDU 100 and/or between the PDU and an external or remote device 125 (e.g., via wireless or wireline communication modes). For example, the network interface card 123 may receive sensor data from an internal sensor 120a and send the data to the remote device 125. In another example, the network interface card 123 may receive PDU status data from the one or more controllers 124 and send the status data to the remote device 125. In another example, the network interface card 123 may receive sensor data from an internal sensor 120 and send the sensor data to one or more controllers 124. In another example, the network interface card 123 may receive log data (e.g., operational data) from the one or more controllers 124 and send the log data to the remote device 125. The network interface card 123 may include any data interface 126, including, but not limited to, an Ethernet interface (e.g., 10/100BaseT) or a serial interface (e.g., RS-232). The network interface card 123 may include any wireless functionality, including, but not limited to, Bluetooth functionality and Wi-Fi functionality. The remote device 125 may include any type of computing, display, or memory device capable of receiving data, including, but not limited to, a server, a laptop, a smartphone, a monitor, or a USB memory stick.

In examples, the remote device 125 may include, be incorporated with, and/or be in communication with, a building management system (BMS). For example, the PDU 100 and/or a power distribution box (PDB) may be configured to signal the BMS about a leak condition, for which the BMS may command the PDU 100 and/or PDB to take action. Alternatively, the PDU 100 and/or PDB may operate autonomously if BMS communications are delayed or inactive. The remote device 125 may include processors and other computing elements in order to facilitate the decision-making roles of the remote device 125, as described herein.

In examples, the PDU 100 includes the one or more controllers 124 communicatively coupled to the relays 109, the one or more sensors 120, 122, and/or other components of the PDU. The one or one or more controllers 124 are configured to control one or more controllable aspects of the PDU 100. The one or more controllers 124 include one or more processors 127 and memory 128, the memory 128 being configured to store instructions that are carried out (i.e., executed) by the one or more processors 127.

In examples, the one or more controllers 124 are configured to receive data from one or more of the internal sensors 120 and/or external sensors 122, and cause the relays 109 to transmit power to the voltage coil 112 (e.g., via disconnect power line 132) of one or more upstream OCPSs 107 upon an indication based on the data from one or more of the internal sensors 120 and/or external sensors 122 of an existence of a liquid leak, such as a coolant leak (e.g., a coolant leak from a server cooling system). For example, the upstream OCPD 107 may be electrically coupled to the PDU 100 via one or more terminal blocks 133, allowing the upstream OCPD to receive the disconnect power from the disconnect power line 132.

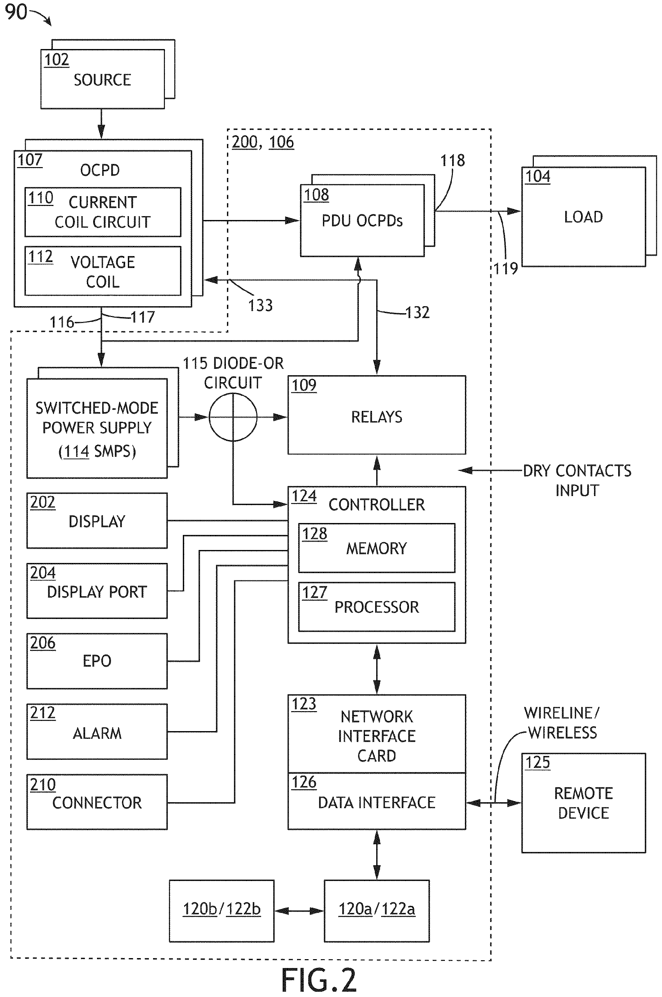

FIG. 2 illustrates a block diagram of a PDU 200, in accordance with one or more examples of the disclosure. The PDU 200 may include one or more examples of the PDU 100, and vice versa.

In examples, the PDU 200 includes a display 202 and/or a display port 204 (e.g., for wireless or wireline connection to an external display) configured to convey information (e.g., status information, log data, alarms) from the PDU 200 to an operator. The display 202 may include any type of display or display technology, including, but not limited to, indicator/alarm lights, LED displays, LCD displays, and OLED displays. In examples, the PDU includes an Emergency Power Off (EPO 206) feature (e.g., a control element) that allows an automatic and/or manual shutdown of the PDU 200. For example, the EPO 206 may include a pressable button or switch that acts as an electrical kill switch when activated by an operator, stopping the flow of power from the power input interface and the plurality of power output interfaces.

In examples, the PDU 200 may include one or more connectors 210 couplable to another PDU 200. For example, the one or more connectors 210 may allow two or more PDUs 200 to be connected together via a daisy chain configuration, allowing multiple PDUs 200 to be powered and/or controlled via a single power source, a single controller, and/or a single data source. In examples, the PDU 200 may further include cable strain relief technology.

In examples, the PDU 200 includes one or more alarms 212 communicatively coupled to the one or more controllers 124, external sensor 122, and/or internal sensor 120. The alarm 212 may be configured to warn an operator of a risk or damage condition (e.g., overcurrent condition or leak detection). The alarm 212 may provide an audio or visual message to the operator.

FIG. 3 is a front view of a PDU 300, in accordance with one or more examples of the disclosure. PDU 300 may include one or more components of PDU 100, 200, and vice versa.

The PDU 300 includes a housing 106 or shell that protects the one or more controller 124 and other componentry of the PDU 300. The housing 106 may be designed to be positioned above a server rack 302 or other electronic device in a horizontal configuration. The housing 106 may also be designed to be positioned adjacent to the server rack 302 or other electronic device in a vertical configuration. Therefore, the description herein should not be interpreted as a limitation on the examples of the present disclosure, but merely as an illustration.

The PDU 300 may include or be couplable to one or more electrical distribution elements 117a-b (e.g., busways). Power may be outputted via more shrouds 119a-d (e.g., sleeves), with each shroud 119a-d including one or more whips 304. For example, the PDU 300 may include any number of electrical distribution elements 117, any number of shrouds 119, and any number of whips 304. The whips 304 may be detachable or non-detachable. The housing 106 may be structured so that the one or more electrical distribution elements 117a-b are connected to the PDU 300 on a first side 305, while the shrouds 119 and whips 304 may be connected to the PDU 300 on a second side 306 (e.g., opposite the third side). By placing the one or more electrical distribution elements 117a-b and shrouds 119/whips 304 on opposite sides, the cabling of the electrical system is less constrained. For example, the one or more electrical distribution elements 117a-b may be connected to power sources above the server rack 302, allowing the shrouds 119 and whips 304 to be placed in the vicinity of the electrical connectors for the server rack 302 without a need for complex bending of either the electrical distribution elements 117a-b, the shrouds 119, or the whips 304. The shrouds 119 and/or whips 304 may be either included as a component of the PDU 300 or as an accessory that is attached to the PDU 300 during installation. Therefore, the description herein should not be interpreted as a limitation on the examples of the present disclosure, but merely as an illustration.

The PDU 300 may include a plurality of OCPDs 108a-h. For example, the PDU 300 may include a separate OCPD 107 for every whip 304. In examples, the OCPDs 108a-h may be configured as circuit breakers. For example, the OCPDs 108a-h may be configured as three-pole circuit breakers (e.g., for input AC power), with each three-pole circuit breaker including at least one current coil circuit 110 and at least one voltage coil 112. In another example, the OCPDs 108a-h may be configured as four-pole circuit breakers, with the fourth pole configured as a neutral pole. For example, an OCPD 108a may include a single current coil circuit 110 and a single voltage coil 112. In another example, an OCPD 108a may include two current coil circuits 110 and two voltage coils 112. In another example, an OCPD 108a may include three current coil circuits 110 and three voltage coils 112 (e.g., a current coil circuit 110 and a voltage coil 112 for each phase of a three-phase AC source 102). The PDU 300 may include a data interface 126 configured to receive a network interface card 123 (e.g., shown inserted into the data interface 126). In another example, an OCPD 108a may include a single current coil circuit 110 and a single voltage coil 112 (e.g., for controlling the flow of DC power). The PDU 300 may include a slot 307 configured to receive a network interface card 123. The data interface 126 may be communicatively coupled to an external display and/or computer (e.g., a smartphone or desktop computer) via wireline and/or wireless technology.

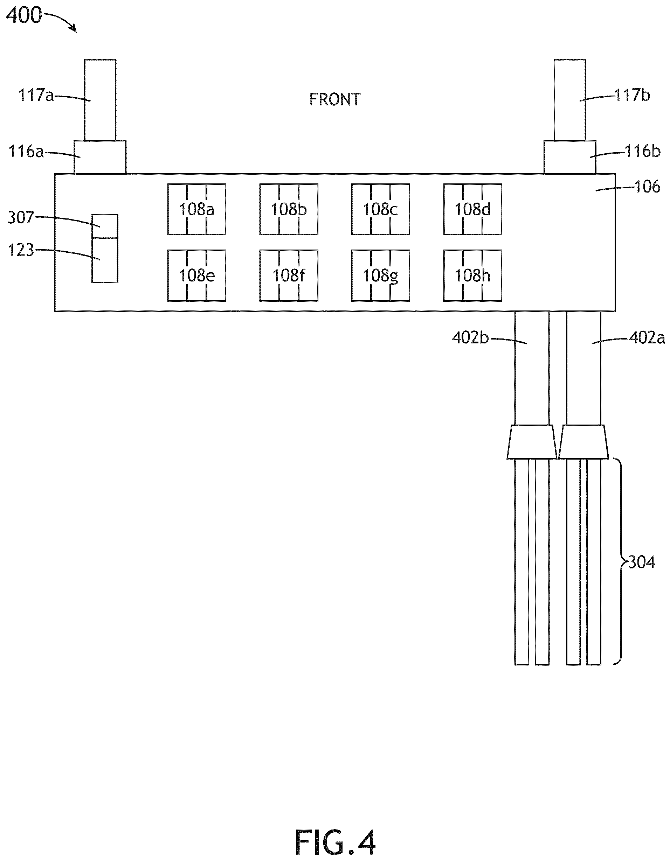

FIG. 4 is a front view of a PDU 400, in accordance with one or more examples of the disclosure. PDU 400 may include one or more components of PDU 100, 200, 300 and vice versa. PDU 400 may include one or more output shrouds 402a, 402b located on one side of the housing 106, each with associated whips 304.

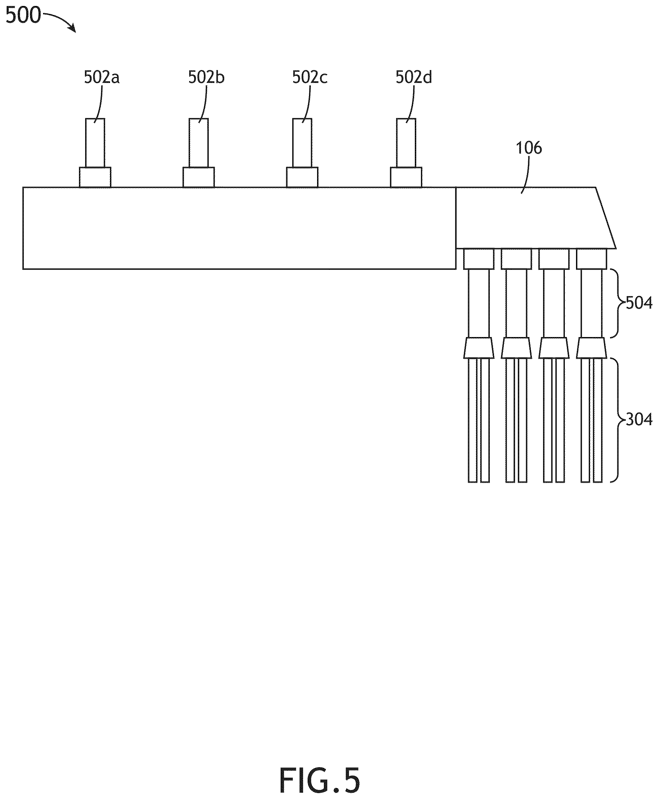

FIG. 5 is a side view of a PDU 500, in accordance with one or more examples of the disclosure. PDU 500 may include one or more components of PDU 100, 200, 300 400, and vice versa. PDU 500 may include a set of electrical distribution elements 502a-d that distribute power to a set of shrouds 504, each with associated whips 304.

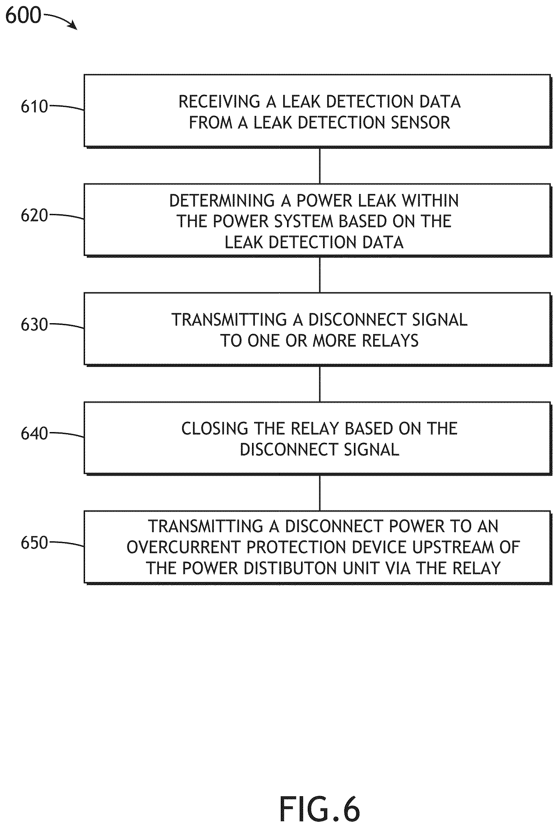

FIG. 6 illustrates a process flow diagram depicting a method 600 for managing leak detection by a power distribution unit, in accordance with one or more examples of the disclosure. The method 600 may be used by any PDU 100, 200, 300, 400, 500 as disclosed herein.

In examples, the method 600 includes a step 610 of receiving leak detection data from a leak detection sensor. For example, the leak detection data may include any data directly or indirectly associated with a coolant leak by any internal sensor 120 or external sensor 122 as described herein.

In examples, the method 600 includes a step 620 of determining if there is a power leak within the power system 90 based on the leak detection data (e.g., via the one or more processors 127. In examples, the method includes a step 630 of, upon a determination of the power leak, transmitting the disconnect signal (e.g., from one or more controllers 124) to the one or more relays 109. In examples, the method 600 includes the step 640 of closing the one or more relays 109 based on the disconnect signal. In examples, the method 600 includes a step 650 of transmitting a disconnect power (e.g., from the SMPS 114) to OCPD 107 via the one or more relays 109. For example, once the disconnect power is received by one or more relays 109, the disconnect power is relayed to the voltage coil 112, causing the OCPD 107 to trip, which stops flow for all power within the PDU 100 (e.g., when one OCPD 107 trips through receiving the disconnect power, the entire PDU 100 is tripped, regardless of other PDU OCPDs 108a-h within the PDU 100), and all devices downstream of the PDU 100 are de-energized.

The method 600 may be utilized in an overarching scheme for protection of one or more power systems 90. For example, upon the alarming configuration (e.g., time and magnitude hysteretic settings), when a leak detection event is registered by the one or more controllers 124, the one or more controllers 124 may autonomously elicit the sequential energization of all the voltage coils 112 by momentarily completing the electrical circuit of the series connection between the power (e.g., voltage) output from the SMPS 114, the voltage coils 112, and a SMPS ground, by closing relay contacts (e.g., relays 109) in the path. The circuit breaker (e.g., OCPD 107) will automatically open and de-energize the rack equipment, and the open condition status is conveyed to the monitoring console (e.g., controller 124 and/or display 202). In another example, the PDU 200 enunciates the leak detection event over the network to allow a building management/control system to acknowledge the event and initiate the shutdown via a remote command. Additionally, the EPO 206 may operatively deenergize multiple server racks.

In examples, the PDU 100 is designed with a redundant wiring scheme (e.g., via the diode-OR circuit 115). For example, the PDU 100 may be designed with N+1 redundancy. For example, the plurality of SMPS 114 may provide for redundant delivery of power to the one or more electronic components of the power system 90 and to the voltage coils 112 of the plurality of OCPSs 107 (e.g., via the relays 109). An N+1 redundancy denotes that the PDU 100 requires a maximum of (e.g., exactly) N supply paths for operation, with at least N+1 supply paths being present in the PDU 100. The N+1 supply path may be set up as a passive standby supply path. If one of the N supply paths fails or needs maintenance, its function may be taken over or maintained by the N+1 supply path (e.g. without having to interrupt the operation of the PDU 100). For example, the voltage outputs of the PDU 100 (e.g., shrouds 119a-d, cables, whips 304, and/or disconnect power lines 132) may be wired in a Boolean "OR" configuration for N+1 redundancy. In this manner the SMPS 114 provide redundant electronic power to the power system 90 and redundant power to energize the voltage coils via the relays 109.

In examples, the PDU 100 is configured as a rack-mounted PDU configured to support high-power demands of power supply units within or coupled to computer servers used for HPC/AI workload processing. For example, the PDU 100 may provide power to IT equipment and CPU/GPU servers directly or indirectly via Open Compute Power (OCP) Open Rack (OR) compliant power shelves while monitoring for the presence of liquid coolant leaks within the same rack space. The PDU 100 may also monitor the server rack sub-floor and/or perimeter for liquid leaks and take immediate protective action to de-energize all the power distribution equipment upon the leak detection event to mitigate the potential of an electrical shock safety hazard. The ability for the PDU 100 to supply power, power monitoring, and liquid leak sensing/monitoring within a rack PDU housing 106 provides convenient, single-point access management of OCPD states. Also, the functionality of the PDU 100 may be flexible and adaptable, and may support management of remotely located OCPDs 107 (e.g., via the display port 204 and/or data interface 126).

In examples, the PDU 100 may provide constructional advantages that overcome traditional high current AC power cable bend radius restrictions. For example, the PDU 100 may include or be couplable via specialized cable, wire harnesses, or other non-traditional construction methods that are not limited by current AC power cable bend radius restrictions. For instance, the construction methods may include over-molded splitting into two or more cables with smaller diameters and flexible braided sleeving. The enclosure form, materials, and construction may also provide a higher ingress protection (IP) rating to prevent liquid ingress.

In examples, the PDU 100 does not include, couple with, or utilize IEC 60309 pin and/or sleeve input power connections. For example, the PDU 100 may include, couple with, or utilize a field wire termination method for enabling power transmission, causing a reduction in material/commissioning costs while improving circuit wiring integrity (e.g., the circuit wiring integrity being less prone to errors). For example, the design of the PDU 100 reduces the lengths and volume of a variety of I/O cabling between remotely separated units of sensing, monitoring, and control, reducing complexity and failure risk. For instance, when integrated into power management systems that utilize supervisory automation, the PDU 100 may reduce the development and commissioning costs for automation algorithms. The consolidation of whips 304 in the design of the PDU 100 allows for optimized routing paths to track along one or both sides of rack space so that bend radius constraints are not violated, while not blocking installation and access other equipment, such as liquid cooling manifolds. The whips may be detachable or non-detachable.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and/or firmware.

The foregoing detailed description has set forth various examples of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one example, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the examples disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative example of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

Further examples are set out in the clauses below:
1. A power distribution unit of a power system for powering electronic equipment, the power distribution unit comprising:
   a housing;
   a power input interface configured to couple to an electrical distribution element;
   a plurality of power output interfaces configured to couple to a plurality of power output cables;
   a plurality of switch-mode power supplies (SMPS) configured to:
      receive a disconnect power; and
      transmit the disconnect power to one or more relays;
      one or more relays configured to transmit the disconnect power to a voltage coil of an overcurrent protective device upon receiving a disconnect signal, wherein the overcurrent protective device is configured to receive a first power from a power source and send the first power to the power distribution unit; and
      a controller communicatively coupled to a leak detection sensor and the one or more relays, the controller including one or more processors configured to execute a set of program instructions stored in a memory, the set of program instructions configured to cause the one or more processors to:
         receive leak detection data from the leak detection sensor;
         determine if there is a power leak within the power system based on the leak detection data; and
         upon a determination of the power leak, transmitting the disconnect signal to the one or more relays.
2. The power distribution unit of clause 1, wherein upon the determination of the power leak, disconnect power is transmitted to all voltage coils of all of the plurality of overcurrent protection devices.
3. The power distribution unit of clause 2, wherein at least one overcurrent protection device of the plurality of overcurrent protection devices is upstream of the power distribution unit.
4. The power distribution unit of any one of the preceding clauses, further comprising the plurality of output cables.
5. The power distribution unit of any one of the preceding clauses, wherein at least one overcurrent protection device of the plurality of overcurrent protection devices comprises a relay trip dual coil.
6. The power distribution unit of any one of the preceding clauses, wherein the first power comprises an alternating current (AC) power.
7. The power distribution unit of clause 6, wherein the AC power comprises three-phase power.
8. The power distribution unit of any one of the preceding clauses, wherein the first power comprises a direct current power.
9. The power distribution unit of any one of the preceding clauses, further comprising a leak detection sensor configured to send leak detection data to the controller.
10. The power distribution unit of any one of the preceding clauses, wherein the housing is configured to house the plurality of SMPS.
11. The power distribution unit of any one of the preceding clauses, further comprising a data interface communicatively coupled to the controller and configured to send operational data from the controller to a remote device.
12. The power distribution unit of any one of the preceding clauses, further comprising a network interface card communicatively coupled to the controller and configured to exchange data between components of the power distribution unit and a remote device.
13. The power distribution unit of any one of the preceding clauses, wherein the power distribution unit is configured to receive the electrical distribution element at a first side of the housing, and receive the plurality of output cables at a second side of the housing that is opposite the first side of the housing.
14. The power distribution unit of any one of the preceding clauses, further comprising at least one of a display or a display port configured to convey information from the power distribution unit to an operator.
15. The power distribution unit of any one of the preceding clauses, further comprising an emergency power off control element configured to stop a flow of power from the power input interface and the plurality of power output interfaces when activated by an operator.
16. The power distribution unit of any one of the preceding clauses, further comprising a connector couplable to another power distribution unit and configured to couple the another power distribution unit in a daisy chain configuration, wherein the power distribution unit and the another power distribution unit are controllable by a single controller.
17. The power distribution unit of any one of the preceding clauses, further comprising an alarm communicatively coupled to the one or more controllers and configured to warn an operator of at least one of a risk condition or a damage condition.
18. The power distribution unit of any one of the preceding clauses, wherein one or more components comprise a redundant wiring scheme, wherein a function of a failed supply path may be maintained by another supply path.
19. The power distribution unit of clause 18, wherein the redundant wiring scheme comprises an N+1 redundancy.
20. A method for managing leak detection by a power distribution unit of a power system, the method comprising:
   receiving a leak detection data from a leak detection sensor;
   determining a power leak within the power system based on the leak detection data;
   transmitting a disconnect signal to one or more relays;
   closing the relay based on the disconnect signal; and
   transmitting a disconnect power to an overcurrent protection device upstream of the power distribution unit via the relay.

While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein.

## Claims

1. A power distribution unit of a power system for powering electronic equipment, the power distribution unit comprising:
a housing;
a power input interface configured to couple to an electrical distribution element;
a plurality of power output interfaces configured to couple to a plurality of power output cables;
a plurality of switch-mode power supplies (SMPS) configured to:
receive a disconnect power; and
transmit the disconnect power to one or more relays;
one or more relays configured to transmit the disconnect power to a voltage coil of an overcurrent protective device upon receiving a disconnect signal, wherein the overcurrent protective device is configured to receive a first power from a power source and send the first power to the power distribution unit; and
a controller communicatively coupled to a leak detection sensor and the one or more relays, the controller including one or more processors configured to execute a set of program instructions stored in a memory, the set of program instructions configured to cause the one or more processors to:
receive leak detection data from the leak detection sensor;
determine if there is a power leak within the power system based on the leak detection data; and
upon a determination of the power leak, transmitting the disconnect signal to the one or more relays.

2. The power distribution unit of claim 1, wherein upon the determination of the power leak, disconnect power is transmitted to all voltage coils of all of the plurality of overcurrent protection devices.

3. The power distribution unit of claim 2, wherein at least one overcurrent protection device of the plurality of overcurrent protection devices is upstream of the power distribution unit.

4. The power distribution unit of any one of the preceding claims, further comprising the plurality of output cables.

5. The power distribution unit of any one of the preceding claims, wherein at least one overcurrent protection device of the plurality of overcurrent protection devices comprises a relay trip dual coil.

6. The power distribution unit of any one of the preceding claims, wherein the first power comprises an alternating current (AC) power.

7. The power distribution unit of claim 6, wherein the AC power comprises three-phase power.

8. The power distribution unit of any one of the preceding claims, wherein the first power comprises a direct current power.

9. The power distribution unit of any one of the preceding claims, further comprising a leak detection sensor configured to send leak detection data to the controller.

10. The power distribution unit of any one of the preceding claims, wherein the housing is configured to house the plurality of SMPS.

11. The power distribution unit of any one of the preceding claims, further comprising a data interface communicatively coupled to the controller and configured to send operational data from the controller to a remote device; or optionally further comprising a network interface card communicatively coupled to the controller and configured to exchange data between components of the power distribution unit and a remote device; or optionally
wherein the power distribution unit is configured to receive the electrical distribution element at a first side of the housing, and receive the plurality of output cables at a second side of the housing that is opposite the first side of the housing; or optionally
further comprising at least one of a display or a display port configured to convey information from the power distribution unit to an operator.

12. The power distribution unit of claim 1, further comprising an emergency power off control element configured to stop a flow of power from the power input interface and the plurality of power output interfaces when activated by an operator; or optionally
further comprising a connector couplable to another power distribution unit and configured to couple the another power distribution unit in a daisy chain configuration, wherein the power distribution unit and the another power distribution unit are controllable by a single controller; or optionally
further comprising an alarm communicatively coupled to the one or more controllers and configured to warn an operator of at least one of a risk condition or a damage condition.

13. The power distribution unit of any one of the preceding claims, wherein one or more components comprise a redundant wiring scheme, wherein a function of a failed supply path may be maintained by another supply path; and optionally

14. The power distribution unit of claim 13, wherein the redundant wiring scheme comprises an N+1 redundancy.

15. A method for managing leak detection by a power distribution unit of a power system, the method comprising:
receiving a leak detection data from a leak detection sensor;
determining a power leak within the power system based on the leak detection data;
transmitting a disconnect signal to one or more relays;
closing the relay based on the disconnect signal; and
transmitting a disconnect power to an overcurrent protection device upstream of the power distribution unit via the relay.
